# EUROPEAN PATENT APPLICATION

(11) **EP 3 882 992 A1**
(43) Date of publication of application: **22.09.2021**
(21) Application number: 19884997.8
(22) Date of filing: 07.11.2019
(51) Int. Cl.: H01L 35/08, H01L 35/14, H02N 11/00

(54) **STANNIDE THERMOELECTRIC CONVERSION ELEMENT AND STANNIDE THERMOELECTRIC CONVERSION MODULE**

(30) Priority: 16.11.2018 JP 2018215395
(71) Applicant: Yasunaga Corporation, Iga-shi, Mie 518-0834 (JP)
(72) Inventor: SAKAMOTO, Tatsuya, Iga-shi, Mie 518-0834 (JP); TAGUCHI, Yutaka, Iga-shi, Mie 518-0834 (JP)
(74) Representative: Epping - Hermann - Fischer
(86) International application number: PCT/JP2019/043710
(87) International publication number: WO 2020/100717

(57) **Abstract**

A stannide thermoelectric conversion module 4 includes a thermoelectric conversion element 2, and an electrode material 8 bonded to the thermoelectric conversion element 2 with a bonding material 6 therebetween, the thermoelectric conversion element 2 is a stannide thermoelectric conversion element including a thermoelectric conversion part 16 containing a stannide compound having composition represented by a general expression: Mg₂Si₁₋ₓSnₓ (where x satisfies relation of 0.5 < x < 1 in the expression), and a first diffusion prevention layer 18 located on a surface of the thermoelectric conversion part 16, wherein the first diffusion prevention layer 18 includes an Mo layer 26, and the bonding material 6 is a non-flowable bonding material 6a having no fluidity.

## Description

### Technical Field

The present invention relates to a stannide thermoelectric conversion element and a stannide thermoelectric conversion module.

### Background Art

A thermoelectric conversion element that converts heat into electricity is used for thermoelectric conversion to generate electricity by utilizing exhaust heat from heat source parts of various devices. The thermoelectric conversion element is disposed between a pair of electrode materials, so that a thermoelectric conversion module is formed. In this thermoelectric conversion module, one end of the thermoelectric conversion element is heated by the exhaust heat from the heat source parts of the various devices, so that a temperature difference is generated between the one end and the other end of the thermoelectric conversion element. Therefore, heat energy is directly converted into electric energy by utilizing a Seebeck effect in which electromotive force is generated in response to this temperature difference.

Such a thermoelectric conversion module has no moving parts and has a simple structure, and therefore is excellent in versatility, and is expected as a means for easily obtaining electric energy by utilizing exhaust heat from devices and the like with exhaust heat.

As the thermoelectric conversion element as described above, for example, an Mg-Si thermoelectric conversion element formed of an Mg-Si thermoelectric conversion material is known.

This Mg-Si thermoelectric conversion element generally has good thermoelectric conversion efficiency in a temperature range of 500°C to 600°C. Therefore, when the Mg-Si thermoelectric conversion element is used in an appropriate temperature range in which the thermoelectric conversion efficiency is good, the performance of the Mg-Si thermoelectric conversion element is most exhibited.

Usually, in a case where the thermoelectric conversion module is manufactured by using the thermoelectric conversion element, it is necessary to bond the thermoelectric conversion element to a metal member as an electrode material, for example, a Cu member, an A1 member or the like. In this case, it is conceivable to perform bonding by using an Ag bonding material such as Ag paste. However, the degree of reactivity between the aforementioned Mg-Si thermoelectric conversion element and Ag is relatively high, and therefore Ag diffuses into the Mg-Si thermoelectric conversion element, and Ag does not remain on an interface, and a good bonding part cannot be formed. Therefore, it is difficult to bond the metal member and the thermoelectric conversion element.

Therefore, a diffusion prevention layer is usually provided on a surface of the thermoelectric conversion material to form a thermoelectric conversion element. When such a diffusion prevention layer is provided, it is possible to suppress the diffusion of Ag into the thermoelectric conversion material, obtain a good bonding part, and form a thermoelectric conversion module in which a thermoelectric conversion element and a metal member are combined. As such a diffusion prevention layer, an Ni layer is generally known.

Some devices that release heat have an exhaust heat temperature lower than the above temperature range. For example, in an automobile engine or the like, exhaust heat of 400°C to 450°C is generated from a heat source. There are relatively many devices that generate exhaust heat in the temperature range of 400°C to 450°C, and it is desired to utilize the exhaust heat in this temperature range.

In a case where an attempt is made to use an Mg-Si thermoelectric conversion element in order to utilize the exhaust heat of 400°C to 450°C, the temperature range is out of the appropriate temperature range of the Mg-Si thermoelectric conversion element, and therefore it is difficult to efficiently generate power.

Therefore, it is considered to use a thermoelectric conversion element having the best thermoelectric conversion efficiency in the temperature range of 400°C to 450°C. Examples of the thermoelectric conversion element having the appropriate temperature range of 400°C to 450°C at which the thermoelectric conversion efficiency is good include an Mg-Si-Sn thermoelectric conversion element formed of an Mg-Si-Sn thermoelectric conversion material disclosed in Patent Document 1, and in particular, a so-called stannide thermoelectric conversion element having a high ratio of Sn to Si.

### Prior Art Document

### Patent Document

Patent Document 1: Japanese Patent Laid-Open No. 2016-157843

### Summary of the Invention

### Problems to be solved by the Invention

Also in a case where a thermoelectric conversion module is manufactured by using the aforementioned stannide thermoelectric conversion element, it is necessary to provide a diffusion prevention layer. However, when the Ni layer as described above is formed as a diffusion prevention layer on a surface of a stannide thermoelectric conversion material containing a relatively large amount of Sn, Sn and Ni in the stannide thermoelectric conversion material are mutually diffused to form a compound of Ni and Sn. In this case, Ni is consumed, the Ni layer partially disappears and does not function as the diffusion prevention layer, and a resistance value of the thermoelectric conversion module as a whole increases. Therefore, a problem that the power generation performance of the thermoelectric conversion module is deteriorated arises.

The present invention has been made in view of the aforementioned circumstances, and an object of the present invention is to provide a stannide thermoelectric conversion element in which deterioration of the power generation performance of a thermoelectric conversion module can be suppressed, and a stannide thermoelectric conversion module using this stannide thermoelectric conversion element.

### Means for Solving the Problems

According to the present invention, there is provided a stannide thermoelectric conversion element including: a thermoelectric conversion part containing a stannide compound having composition represented by a general expression: Mg₂Si₁₋ₓSnₓ (where x satisfies relation of 0.5 < x < 1 in the expression); and a diffusion prevention layer located on a surface of the thermoelectric conversion part, wherein the diffusion prevention layer includes an Mo layer.

The diffusion prevention layer preferably further includes: a first adhesion layer disposed between the Mo layer and the thermoelectric conversion part; and a second adhesion layer disposed on a side opposite to the first adhesion layer so as to interpose the Mo layer.

The first adhesion layer and the second adhesion layer preferably each include a Ti layer.

Surface roughness Rz of the surface of the thermoelectric conversion part is preferably 0.1 µm or more and 3 µm or less.

The stannide thermoelectric conversion element preferably further includes an antioxidant layer disposed on a side opposite to the thermoelectric conversion part so as to interpose the diffusion prevention layer.

The antioxidant layer preferably includes at least one metal layer of an Au layer, an Ag layer and a Cu layer.

According to the present invention, there is provided a stannide thermoelectric conversion module including: a thermoelectric conversion element; and an electrode material bonded to the thermoelectric conversion element with a bonding material therebetween, wherein the thermoelectric conversion element is any of the aforementioned stannide thermoelectric conversion elements, and the bonding material includes a non-flowable bonding material having no fluidity.

The non-flowable bonding material preferably includes at least one of an Ni plating layer and an Au plating layer.

The non-flowable bonding material preferably includes foil made of Ag.

According to the present invention, there is provided a stannide thermoelectric conversion module including: a thermoelectric conversion element; and an electrode material directly bonded to the thermoelectric conversion element with no bonding material therebetween, wherein the thermoelectric conversion element is any of the aforementioned stannide thermoelectric conversion elements.

### Advantageous Effects of the Invention

A stannide thermoelectric conversion element of the present invention includes: a thermoelectric conversion part containing a stannide compound having composition represented by a general expression: Mg₂Si₁₋ₓSnₓ (where x satisfies relation of 0.5 < x < 1 in the expression); and a diffusion prevention layer located on a surface of the thermoelectric conversion part, wherein the diffusion prevention layer includes an Mo layer. Mo does not mutually diffuse with Sn in the stannide compound, and therefore the Mo layer does not partially disappear, and sufficiently functions as the diffusion prevention layer. Therefore, in the stannide thermoelectric conversion module including the stannide thermoelectric conversion element according to the present invention, increase of a resistance value as a whole is suppressed. Accordingly, according to the present invention, it is possible to provide a stannide thermoelectric conversion module in which deterioration of power generation performance is suppressed.

### Brief Description of the Drawings

FIG. 1 is a perspective view schematically illustrating a configuration of a stannide thermoelectric conversion module according to an embodiment
FIG. 2 is a perspective view schematically illustrating a configuration of a stannide thermoelectric conversion element according to an embodiment.
FIG. 3 is a perspective view schematically illustrating a procedure for manufacturing the thermoelectric conversion element.
FIG. 4 is a side view schematically illustrating a mode in which a thermoelectric conversion element and an electrode material are directly bonded.
FIG. 5 is a side view schematically illustrating a mode in which a thermoelectric conversion element and the electrode material are bonded with metal foil therebetween.
FIG. 6 is a side view schematically illustrating a mode in which a thermoelectric conversion element and an electrode material are bonded with a metal layer therebetween.
FIG. 7 is a side view schematically illustrating a mode in which a thermoelectric conversion element and an electrode material are bonded with a metal layer and a flowable bonding material therebetween.

### Mode for Carrying out the Invention

An embodiment of a stannide thermoelectric conversion module 4 (hereinafter referred to as a thermoelectric conversion module 4) including a stannide thermoelectric conversion element 2 (hereinafter referred to as a thermoelectric conversion element 2) according to the present invention will be described below with reference to the drawings.

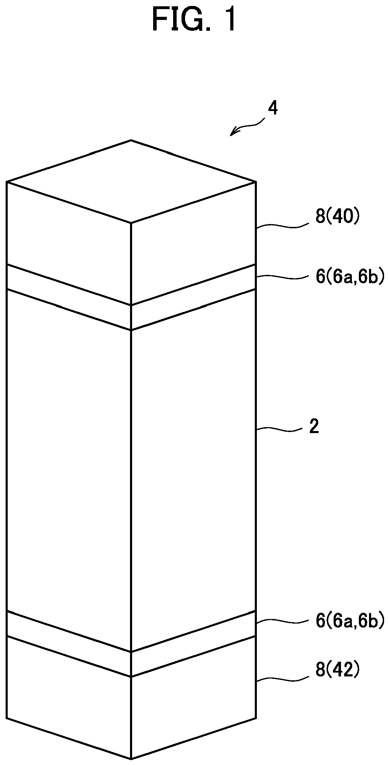

As illustrated in FIG. 1, the thermoelectric conversion module 4 includes the thermoelectric conversion element 2, and electrode materials 8 bonded to one end and the other end of this thermoelectric conversion element 2 with bonding materials 6 therebetween.

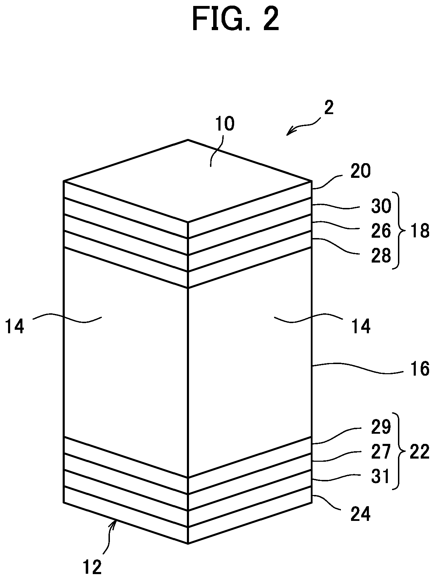

As illustrated in FIG. 2, an overall shape of the thermoelectric conversion element 2 is a quadrangular column having a quadrangular cross section. Specifically, the quadrangular column has a square one end face 10, a square other end face 12 located on a side opposite to this one end face 10, and four rectangular side surfaces 14 each extending between a peripheral edge of the one end face 10 and a peripheral edge of the other end face 12. The shape of the thermoelectric conversion element 2 is not particularly limited, and a polygonal column having a polygonal cross section, a cylindrical column having a circular cross section, or the like may be adopted in addition to the quadrangular column having the quadrangular cross section.

Such a thermoelectric conversion element 2 includes a thermoelectric conversion part 16 as a base, a first diffusion prevention layer 18 formed on one end side of the thermoelectric conversion part 16, a first antioxidant layer 20 formed on one end side of this first diffusion prevention layer 18, a second diffusion prevention layer 22 formed on the other end side of the thermoelectric conversion part 16, and a second antioxidant layer 24 formed on the other end side of this second diffusion prevention layer 22.

The thermoelectric conversion part 16 is formed of a stannide compound having composition represented by general expression: Mg₂Si₁₋ₓSnₓ (where x satisfies the relation of 0.5 < x < 1 in the expression).

The first diffusion prevention layer 18 and the first antioxidant layer 20, and the second diffusion prevention layer 22 and the second antioxidant layer 24 have a symmetrical structure with the thermoelectric conversion part 16 interposed therebetween. Therefore, only the first diffusion prevention layer 18 and the first antioxidant layer 20 on the one end side will be described, and detailed description of the second diffusion prevention layer 22 and the second antioxidant layer 24 on the other end face side will be omitted.

The first diffusion prevention layer 18 serves to prevent the diffusion of various elements from the bonding material 6 to the thermoelectric conversion part 16 side and to prevent the diffusion of various elements from the thermoelectric conversion part 16 side.

The first diffusion prevention layer 18 includes an Mo layer 26. The Mo layer 26 serves to prevent Ag in the Ag bonding material used as needed when forming the thermoelectric conversion module 4 from diffusing into the thermoelectric conversion part, and to prevent Mg from diffusing from the thermoelectric conversion part 16. In particular, the Mo layer 26 does not mutually diffuse with Sn in the stannide compound unlike a conventional diffusion prevention layer of Ni, and is therefore most suitable as the diffusion prevention layer of the stannide thermoelectric conversion element.

However, the Mo layer 26 described above does not have very good bondability with other materials. Therefore, it is preferable that the first diffusion prevention layer 18 further includes a first adhesion layer 28 and a second adhesion layer 30 so as to interpose the Mo layer 26.

Specifically, the first adhesion layer 28 is preferably formed between one end face of the thermoelectric conversion part 16 and the Mo layer 26. As this first adhesion layer 28, a Ti layer is preferably used. This Ti layer has good bondability with the stannide compound as the thermoelectric conversion part 16, and has relatively good bondability with the Mo layer 26. Therefore, the Ti layer contributes to improvement of the adhesion between the Mo layer 26 and the thermoelectric conversion part 16.

The second adhesion layer 30 is preferably formed on the side opposite to the first adhesion layer 28 so as to interpose the Mo layer 26. As this second adhesion layer 30, the Ti layer is preferably used.

Ti is an active metal, and therefore easily oxidized, and an oxide film is immediately formed on a surface of the Ti layer. When the oxide film is thus formed, a trouble in bonding with other materials may be caused. Therefore, the first antioxidant layer 20 for preventing the oxidation of the second adhesion layer 30 is preferably formed on a surface of the second adhesion layer 30, that is, a surface of the first diffusion prevention layer 18. This first antioxidant layer 20 preferably includes at least one metal layer of an Au layer, an Ag layer, and a Cu layer.

Herein, in FIG. 2, reference numeral 27 denotes an Mo layer in the second diffusion prevention layer 22, reference numeral 29 denotes a first adhesion layer in the second diffusion prevention layer 22, and reference numeral 31 denotes a second adhesion layer in the second diffusion prevention layer 22, and reference numeral 24 denotes a second antioxidant layer that prevents oxidation of the second adhesion layer 31.

The thermoelectric conversion element 2 as described above can be manufactured, for example, as follows.

First, Mg, Si and Sn are measured such that the composition satisfies Mg₂Si₁₋ₓSnₓ (where x satisfies the relationship of 0.5 <x <1), and respective predetermined amounts of Mg, Si and Sn are mixed to obtain a mixture. The obtained mixture is put into an induction melting furnace, and thereafter is heated and melted in an argon gas atmosphere. Then, the obtained melt is cooled to a room temperature (about 25°C) to prepare an ingot. The obtained ingot is mechanically crushed. Consequently, powder of a stannide compound which is an aggregate of particles having desired particle size can be obtained.

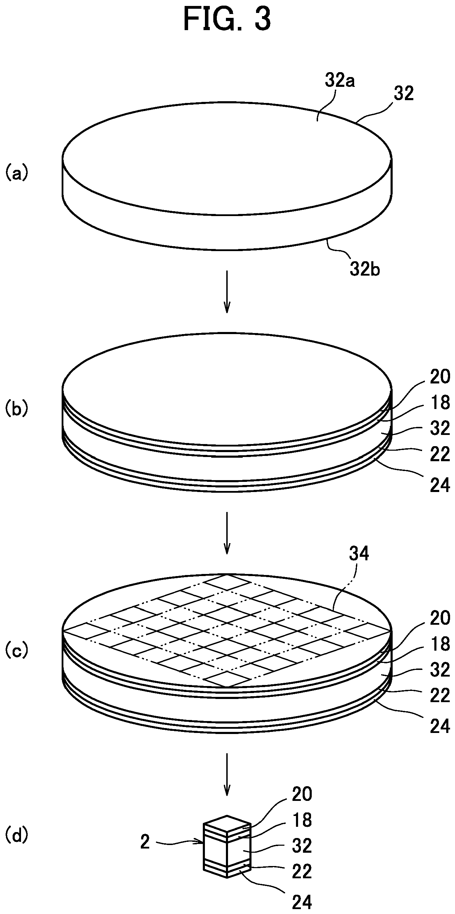

The obtained powder is sintered at predetermined sintering pressure and a predetermined sintering temperature in a graphite sintering jig under a vacuum or reduced pressure atmosphere by a pressure compression sintering method to obtain a disk-shaped sintered body 32 as illustrated in FIG. 3(a).

Then, both end faces 32a and 32b of the obtained sintered body 32 are polished. This polishing work is preferably performed by a buffing apparatus using diamond paste containing diamond particles having predetermined particle size.

As illustrated in FIG. 3(b), the first diffusion prevention layer 18 and the second diffusion prevention layer 22 are formed on the both end faces 32a and 32b of the sintered body 32 obtained after the polishing work, respectively. Specifically, the Ti layer as the first adhesion layer 28 is formed on the one end face 32a of the sintered body 32. Then, the Mo layer 26 is formed on a surface of the first adhesion layer 28. Thereafter, the Ti layer as the second adhesion layer 30 is formed on a surface of the Mo layer 26. Thus, the first diffusion prevention layer 18 is formed.

Then, the first antioxidant layer 20 is formed on the surface of the first diffusion prevention layer 18. That is, any one of the Au layer, the Ag layer and the Cu layer, or a composite layer obtained by combining any of these layers is formed on the surface of the first diffusion prevention layer 18. Thus, the first antioxidant layer 20 is formed.

Thereafter, the Ti layer as the first adhesion layer 29 is formed on the other end face 32b. Then, the Mo layer 27 is formed on a surface of the first adhesion layer 29. Thereafter, the Ti layer as the second adhesion layer 31 is formed on a surface of the Mo layer 27. Thus, the second diffusion prevention layer 22 is formed.

Then, the second antioxidant layer 24 is formed on a surface of the second diffusion prevention layer 22. That is, any one of the Au layer, the Ag layer and the Cu layer, or a composite layer obtained by combining any of these layers is formed on the surface of the second diffusion prevention layer 22. Thus, the second antioxidant layer 24 is formed.

Herein, a method for forming the respective layers constituting the first diffusion prevention layer 18, the first antioxidant layer 20, the second diffusion prevention layer 22, and the second antioxidant layer 24 is not particularly limited. However, for example, a sputtering method is preferably used. In addition to the sputtering method, a thin film deposition method from a gas phase such as a vacuum vapor deposition method and a CVD method, or a thin film deposition method from a liquid phase such as a plating method may be used.

In the aforementioned polishing work, the surface roughness Rz of the one end face 32a and the other end face 32b (one end face and the other end face of the thermoelectric conversion part 16) of the sintered body 32 is preferably 0.1 µm or more and 3 µm or less. In a case where a diffusion prevention layer, an adhesion layer, or the like is formed by dry coating (particularly a physical film formation method) such as sputtering and vacuum deposition, it is difficult to obtain a good thin film when Rz is less than 0.1 µm. That is, when the surface roughness Rz is not 0.1 µm or more, the adhesion between the thermoelectric conversion part and the diffusion prevention layer, the adhesion layer and the like cannot be maintained. As a result, a good thin film cannot be obtained. On the contrary, when Rz exceeds 3 µm, the surface of the thermoelectric conversion part becomes too rough, and it becomes difficult to bond the thermoelectric conversion part with the electrode material described later. Therefore, the value of Rz is preferably set within the above range.

The sintered body 32 having the first diffusion prevention layer 18, the first antioxidant layer 20, the second diffusion prevention layer 22 and the second antioxidant layer 24 obtained as described above is cut in a grid pattern by insertion of a wire saw blade (not illustrated), as illustrated in FIG. 3(c), and the thermoelectric conversion element 2 as illustrated in FIG. 3(d) is cut out. Thus, a plurality of the quadrangular columnar thermoelectric conversion elements 2 are cut out of the sintered body 32. In FIG. 3(c), the grid pattern indicated by reference numeral 34 indicates a place where the wire saw blade (not illustrated) is to be inserted.

Now, the thermoelectric conversion module 4 including the thermoelectric conversion element 2 obtained as described above will be described.

As illustrated in FIG. 1, the thermoelectric conversion module 4 includes the thermoelectric conversion element 2, the respective electrode materials 8 disposed on the one end and the other end of this thermoelectric conversion element 2. The electrode material 8 on the one end described above functions as, for example, a high temperature side electrode 40. Further, the electrode material 8 on the other end described above functions as, for example, a low temperature side electrode 42. Herein, as the electrode material 8 described above, a metal member such as a Cu member and an A1 member is preferably used, and the Cu member is more preferably used from the viewpoint of cost and productivity. The shape of the metal member (Cu member or the like) used for the electrode material may be any shape such as a block shape and a plate shape.

In the thermoelectric conversion module 4, electric power can be obtained when a temperature difference occurs between the high temperature side electrode 40 and the low temperature side electrode 42. Such a thermoelectric conversion module 4 can be manufactured, for example, as follows.

The thermoelectric conversion module 4 is manufactured by bonding the thermoelectric conversion element 2 and the electrode materials 8. Generally, Ag paste is used as the bonding material 6 for bonding the thermoelectric conversion element 2 and the electrode materials 8. However, in the present invention, when the thermoelectric conversion element 2 and the electrode materials are bonded, the bonding is not preferably performed by using only a flowable bonding material such as Ag paste. In the thermoelectric conversion element 2 according to the present invention, gaps such as cracks may occur in the Mo layers 26 and 27. In a case where such gaps occur, when the flowable Ag paste is used, there is a possibility that a problem that the Ag paste enters the gaps and Ag diffuses into the thermoelectric conversion part 16 from the gaps occurs. Therefore, in the present invention, the thermoelectric conversion element 2 and the electrode materials 8 (Cu members) are bonded by minimizing the use of the flowable bonding material. Preferably, as the bonding materials 6, non-flowable bonding materials 6a having no fluidity are adopted to bond the thermoelectric conversion element 2 and the electrode materials 8 (Cu members). As the bonding materials 6, the thermoelectric conversion element 2 and the electrode materials 8 (Cu members) may be bonded by combining the non-flowable bonding materials 6a and a smaller amount of the flowable bonding materials 6b than conventional ones. Further, more preferably, a mode in which the thermoelectric conversion element 2 and the electrode materials 8 (Cu members) are directly bonded is adopted.

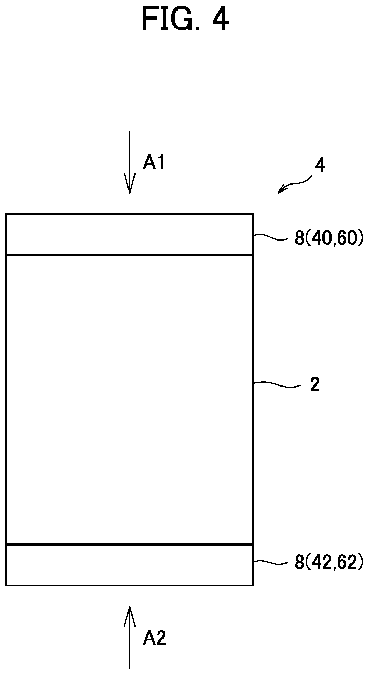

Herein, as a mode of direct bonding, as illustrated in FIG. 4, in a state in which the electrode materials 8 (Cu members) are in direct contact with one end and the other end of the thermoelectric conversion element 2, the thermoelectric conversion element 2 and the electrode materials 8 (Cu members) are heated while being pressurized in such directions as to approach each other, as illustrated by the arrows A1 and A2. Consequently, the thermoelectric conversion element 2 and the electrode materials 8 (Cu members) are diffused and bonded.

On the other hand, examples of a mode in which the non-flowable bonding material 6a is used include a method of using various metal foils as the bonding material and a method of previously forming metal layers as the bonding materials on the surfaces of the electrode materials 8 (Cu members).

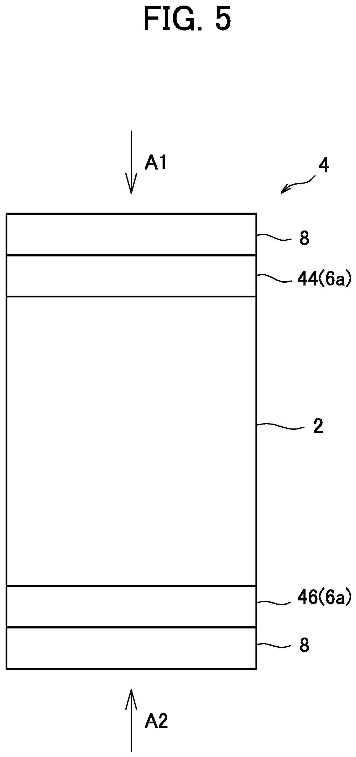

In the method using the metal foil described above, as illustrated in FIG. 5, metal foils 44 and 46 are disposed between the thermoelectric conversion element 2 and the electrode materials 8 (Cu members), and in this state, the thermoelectric conversion element 2 and the electrode materials 8 (Cu members) are heated while being pressurized in such directions as to approach each other as illustrated by the arrows A1 and A2. Consequently, diffusion bonding is performed between the thermoelectric conversion element 2 and the metal foils 44 and 46 and between the metal foils 44 and 46 and the electrode materials 8 (Cu members). As the aforementioned metal foils 44 and 46, foil made of Ag is preferably used. Further, foil made of Au, foil made of Ni or the like can also be used.

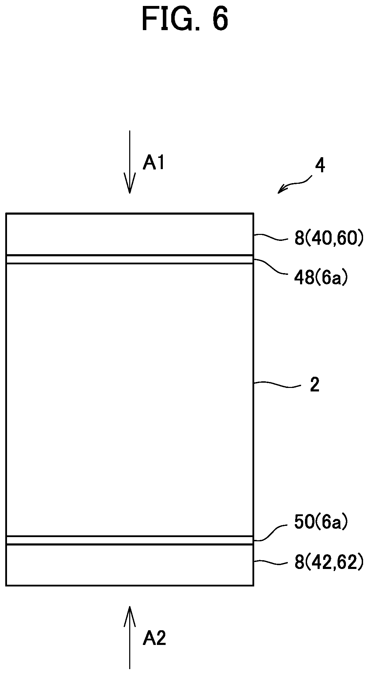

In the method of forming the metal layers on the surfaces of the electrode materials 8 (Cu members), as illustrated in FIG. 6, in a state in which the respective electrode materials 8 (Cu members) having surfaces previously formed with metal layers 48 and 50 thereon are in contact with the thermoelectric conversion element 2, the thermoelectric conversion element 2 and the electrode materials 8 (Cu members) are heated while being pressurized in such directions as to approach each other, as illustrated by the arrows A1 and A2. Consequently, diffusion bonding is performed between the thermoelectric conversion element 2 and the metal layers 48 and 50 and between the metal layers 48 and 50 and the electrode materials 8 (Cu members). Ni and Au plating layers may be preferably used as the metal layers 48 and 50 on the surfaces of the electrode materials 8 (Cu members).

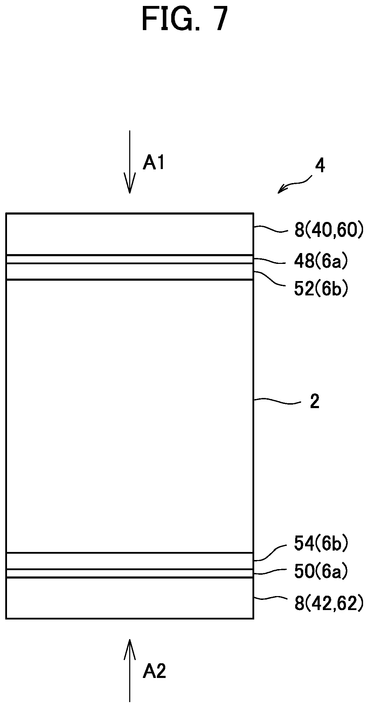

In a mode in which the non-flowable bonding material 6a and the flowable bonding material 6b are combined to bond the electrode materials 8 (Cu members) and the thermoelectric conversion element 2, as illustrated in FIG. 7, Ag pastes 52 and 54 as the flowable bonding materials 6b are disposed between electrode materials 8 (Cu members) having surfaces previously formed with metal layers 48 and 50, and the thermoelectric conversion element 2, and in this state, the thermoelectric conversion element 2 and the electrode materials 8 (Cu members) are heated while being pressurized in such directions as to approach each other, as illustrated by arrows A1 and A2. Consequently, bonding layers are formed and bonding is performed between the thermoelectric conversion element 2 and the Ag pastes 52 and 54, and between the Ag pastes 52 and 54 and the metal layers 48 and 50.

Herein, the metal layers 48 and 50 formed on the surfaces of the aforementioned electrode materials 8 (Cu members) only need to be at least formed on surfaces of the electrode materials 8 (Cu members) facing the thermoelectric conversion element 2. However, the metal layers 48 and 50 may cover the entire electrode materials 8 (Cu members).

The thermoelectric conversion element 2 according to the present invention includes the Mo layer in the diffusion prevention layer. Mo does not mutually diffuse with Sn, and therefore effectively functions as the diffusion prevention layer of the thermoelectric conversion element formed of a stannide compound containing a large amount of Sn. Therefore, the thermoelectric conversion module 4 including the thermoelectric conversion element 2 is an excellent thermoelectric conversion module in which deterioration of power generation performance is suppressed.

In the above description, the thermoelectric conversion module 4 composed of only one thermoelectric conversion element 2 is described as an example. However, a thermoelectric conversion module composed of a plurality of the thermoelectric conversion elements 2, for example, a uni-leg type thermoelectric conversion module in which either p-type thermoelectric conversion elements 2 or n-type thermoelectric conversion elements 2 are connected in series, or a π-type thermoelectric conversion module in which p-type and n-type thermoelectric conversion elements 2 are connected alternately in series may be used.

### [Example]

### 1. Manufacture of Thermoelectric Conversion Module

### (Example 1)

### (1) Manufacture of Thermoelectric Conversion Element

Mg, Si and Sn were measured such that the composition was Mg₂Si_{0.3}Sn_{0.7}, a predetermined amount of Mg, Si and Sn was mixed to obtain a mixture. The obtained mixture was put into an induction melting furnace and then heated and melted in an argon gas atmosphere. Thereafter, the obtained melt was cooled to a room temperature (about 25°C) to prepare an ingot. The obtained ingot was mechanically pulverized to obtain powder of Mg₂Si_{0.3}Sn_{0.7} composed of particles having average particle size of several tens of µm.

The obtained powder was put into a graphite sintering jig, and sintered at sintering pressure of 50 MPa and a sintering temperature of 680°C under a reduced pressure atmosphere of 5 × 10⁻³ Pa or less. As a result, a disk-shaped sintered body 32 as illustrated in FIG. 3(a) was obtained.

Then, both end faces 32a and 32b of the obtained sintered body 32 were buffed. At this time, diamond paste containing diamond particles having particle size of 0.5 µm was used. The surface roughness (Rz) of the both end faces 32a and 32b was set to 1.5 ± 0.1 µm by the aforementioned buffing work. That is, the surface roughness (Rz) of each of the surfaces of the one end and the other end of the thermoelectric conversion part 16 is 1.5 ± 0.1 µm.

Respective Ti layers that became first adhesion layers 28 and 29 were formed on the both end faces 32a and 32b of the sintered body 32 obtained after the buffing work was completed, by a sputtering method. The thickness of each of the first adhesion layers 28 and 29 was set to 3 µm.

Then, respective Mo layers 26 and 27 were formed on the first adhesion layers 28 and 29 by a sputtering method. The thickness of each of the Mo layers 26 and 27 was set to 3 µm.

Then, respective Ti layers that became second adhesion layers 30 and 31 were formed on the Mo layers 26 and 27 by a sputtering method. The thickness of each of the second adhesion layers 30 and 31 was set to 0.2 µm.

As described above, first and second diffusion prevention layers 18 and 22 including the first and second adhesion layers 28 and 29, the Mo layers 26 and 27, and the second adhesion layers 30 and 31 were formed on the both end faces 32a and 32b of the sintered body 32.

Then, respective Ag layers that became first and second antioxidant layers 20 and 24 were formed on the second adhesion layers 30 and 31 of the first and second diffusion prevention layers 18 and 22, by a sputtering method. The thickness of each Ag layer was 0.2 µm.

As described above, the first and second diffusion prevention layers 18 and 22, and the first and second antioxidant layers 20 and 24 were formed on the both end faces 32a and 32b of the sintered body 32, as illustrated in FIG. 3(b).

As illustrated in FIG. 3(c), the sintered body 32 having the first and second diffusion prevention layers 18 and 22 and the first and second antioxidant layers 20 and 24 thus obtained was cut in a grid pattern by insertion of a wire saw blade (not illustrated), and a thermoelectric conversion element 2 as illustrated in FIG. 3(d) was cut out. Thus, the quadrangular columnar thermoelectric conversion element 2 was obtained from the sintered body 32.

### (2) Manufacture of Thermoelectric Conversion Module

The thermoelectric conversion element 2 obtained as described above and electrode materials 8 (Cu members) were set in a bonding device, and were bonded. Specifically, as illustrated in FIG. 4, a first Cu member 60 was brought into contact with one end face of the thermoelectric conversion element 2, and a second Cu member 62 was brought into contact with the other end face of the thermoelectric conversion element 2. That is, the thermoelectric conversion element 2 was interposed between the first Cu member 60 and the second Cu member 62. Then, while the first Cu member 60 and the second Cu member 62 were pressurized in such directions that the first Cu member 60 and the second Cu member 62 approach each other (directions indicated by the arrows A1 and A2), the first Cu member 60 and the second Cu member 62, and the thermoelectric conversion element 2 were heated to 350°C and held for 15 minutes to be directly bonded.

Thereafter, a bonded body including the first Cu member 60, the second Cu member 62 and the thermoelectric conversion element 2 was taken out of the bonding device.

Then, the bonded body taken out of the bonding device was put into a vacuum furnace having pressure reduced to 5 × 10⁻³ Pa or less. Then, the bonded body was heated to 450°C and held for 1 hour to be subjected to post heating treatment. After 1 hour, the bonded body was cooled to a room temperature of 25°C, and then taken out of the vacuum furnace. Consequently, a thermoelectric conversion module 4 was obtained.

### (Example 2)

A thermoelectric conversion module 4 was manufactured in the same manner as in Example 1 except that buffing of both end faces 32a and 32b of a sintered body 32 was performed by using diamond paste containing diamond particles having particle size of 3 µm, and the surface roughness (Rz) of each of the both end faces 32a and 32b was set to 4.0 ± 0.2 µm by the aforementioned buffing work.

### (Example 3)

A thermoelectric conversion module 4 was manufactured in the same manner as in Example 1 except that a composite plating layer as a metal layer composed of an Ni plating layer and an Au plating layer was previously formed on each of surfaces of electrode materials 8 (Cu members) at the time of the manufacture of the thermoelectric conversion module, and bonding is performed in a state in which metal layers (composite plating layers each composed of the Ni plating layer and the Au plating layer) 48 and 50 existed between one end face of the thermoelectric conversion element 2 and a first Cu member 60 and between the other end face of the thermoelectric conversion element 2 and a second Cu member 62, as illustrated in FIG. 6.

That is, Example 3 is a mode in which the non-flowable bonding materials 6a were used.

The Ni plating layers were formed on the surfaces of the electrode materials 8 (Cu members), and thereafter Au plating layers were formed on the Ni plating layers. At this time, the thickness of each Ni plating layer was several µm, and the thickness of each Au plating layer was several hundred nm.

### (Example 4)

A thermoelectric conversion module 4 was manufactured in the same manner as in Example 1 except that buffing of both end faces 32a and 32b of a sintered body 32 was performed by using diamond paste containing diamond particles having particle size of 3 µm, the surface roughness (Rz) of each of the both end faces 32a and 32b was set to 4.0 ± 0.2 µm by the aforementioned buffing work, a composite plating layer as a metal layer composed of an Ni plating layer and an Au plating layer was previously formed on each of surfaces of electrode materials 8 (Cu members) at the time of the manufacture of the thermoelectric conversion module, and bonding is performed in a state in which metal layers (composite plating layers each composed of the Ni plating layer and the Au plating layer) 48 and 50 existed between one end face of the thermoelectric conversion element 2 and a first Cu member 60 and between the other end face of the thermoelectric conversion element 2 and a second Cu member 62, as illustrated in FIG. 6.

That is, Example 4 is a mode in which the non-flowable bonding materials 6a were used.

The Ni plating layers were formed on the surfaces of the electrode materials 8 (Cu members), and thereafter the Au plating layers were formed on the Ni plating layers. At this time, the thickness of each Ni plating layer was several µm, and the thickness of each Au plating layer was several hundred nm.

### (Comparative Example 1)

A thermoelectric conversion module 4 was manufactured in the same manner as in Example 1 except that buffing of both end faces 32a and 32b of a sintered body 32 was performed by using diamond paste containing diamond particles having particle size of 6 µm, the surface roughness (Rz) of each of the both end faces 32a and 32b was set to 4.7 ± 0.1 µm by the aforementioned buffing work, the thickness of each Ti layer as a first adhesion layer was set to 0.2 µm, Ni layers each having the thickness of 3 µm were formed in place of Mo layers by a sputtering method, no second adhesion layer was formed, Au layers each having a thickness of 0.1 µm were formed as antioxidant layers on Ni, a composite plating layer as a metal layer composed of an Ni plating layer and an Au plating layer was previously formed on each of surfaces of electrode materials 8 (Cu members) at the time of the manufacture of the thermoelectric conversion module, and bonding is performed in a state in which metal layers (composite plating layers each composed of the Ni plating layer and the Au plating layer) 48 and 50 existed between one end face of the thermoelectric conversion element 2 and a first Cu member 60 and between the other end face of the thermoelectric conversion element 2 and a second Cu member 62, as illustrated in FIG. 6.

That is, Comparative Example 1 is a mode in which the non-flowable bonding materials 6a were used.

The Ni plating layers were formed on the surfaces of the electrode materials 8 (Cu members), and thereafter the Au plating layers were formed on the Ni plating layers. At this time, the thickness of each Ni plating layer was several µm, and the thickness of each Au plating layer was several hundred nm.

### (Example 5)

A thermoelectric conversion module 4 was manufactured in the same manner as in Example 1 except that a composite plating layer as a metal layer composed of an Ni plating layer and an Au plating layer was previously formed on each of surfaces of electrode materials 8 (Cu members) at the time of the manufacture of the thermoelectric conversion module, Ag paste 52 as the flowable bonding material 6b is disposed between a metal layer (composite plating layer composed of the Ni plating layer and the Au plating layer) 48 formed on a first Cu member 60 and one end face of a thermoelectric conversion element 2, and Ag paste 54 as the flowable bonding material 6b is disposed between a metal layer (composite plating layer composed of the Ni plating layer and the Au plating layer) 50 formed on a second Cu member 62 and the other end face of the thermoelectric conversion element 2, as illustrated in FIG. 7.

That is, Example 5 is a mode in which the non-flowable bonding materials 6a and the flowable bonding materials 6b were used.

The Ni plating layers were formed on the surfaces of the electrode materials 8 (Cu members), and thereafter the Au plating layers were formed on the Ni plating layers. At this time, the thickness of each Ni plating layer was several µm, and the thickness of each Au plating layer was several hundred nm.

### (Example 6)

A thermoelectric conversion module 4 was manufactured in the same manner as in Example 1 except that buffing of both end faces 32a and 32b of a sintered body 32 was performed by using diamond paste containing diamond particles having particle size of 3 µm, the surface roughness (Rz) of each of the both end faces 32a and 32b was set to 4.0 ± 0.2 µm by the aforementioned buffing work, a composite plating layer as a metal layer composed of an Ni plating layer and an Au plating layer was previously formed on each of surfaces of electrode materials 8 (Cu members) at the time of the manufacture of the thermoelectric conversion module, Ag paste 52 as the flowable bonding material 6b was disposed between a metal layer (composite plating layer composed of the Ni plating layer and the Au plating layer) 48 formed on a first Cu member 60 and one end face of a thermoelectric conversion element 2, and Ag paste 54 as the flowable bonding material 6b was disposed between a metal layer (composite plating layer composed of the Ni plating layer and the Au plating layer) 50 formed on a second Cu member 62 and the other end face of the thermoelectric conversion element 2, as illustrated in FIG. 7.

That is, Example 6 is a mode in which the non-flowable bonding materials 6a and the flowable bonding materials 6b were used.

The Ni plating layers were formed on the surfaces of the electrode materials 8 (Cu members), and thereafter the Au plating layers were formed on the Ni plating layers. At this time, the thickness of each Ni plating layer was several µm, and the thickness of each Au plating layer was several hundred nm.

### (Comparative Example 2)

A thermoelectric conversion module 4 was manufactured in the same manner as in Example 1 except that buffing of both end faces 32a and 32b of a sintered body 32 was performed by using diamond paste containing diamond particles having particle size of 6 µm, the surface roughness (Rz) of each of the both end faces 32a and 32b was set to 4.7 ± 0.1 µm by the aforementioned buffing work, the thickness of each Ti layer as a first adhesion layer was set to 0.2 µm, Ni layers each having the thickness of 3 µm were formed in place of Mo layers by a sputtering method, no second adhesion layer was formed, Au layers each having a thickness of 0.1 µm were formed as antioxidant layers on Ni, a composite plating layer as a metal layer composed of an Ni plating layer and an Au plating layer was previously formed on each of surfaces of electrode materials 8 (Cu members) at the time of the manufacture of the thermoelectric conversion module, Ag paste 52 as the flowable bonding material 6b was disposed between a metal layer (composite plating layer composed of the Ni plating layer and the Au plating layer) 48 formed on a first Cu member 60 and one end face of a thermoelectric conversion element 2, and Ag paste 54 as the flowable bonding material 6b was disposed between a metal layer (composite plating layer composed of the Ni plating layer and the Au plating layer) 50 formed on a second Cu member 62 and the other end face of the thermoelectric conversion element 2, as illustrated in FIG. 7.

That is, Comparative Example 2 is a mode in which the non-flowable bonding materials 6a and the flowable bonding materials 6b were used.

The Ni plating layers were formed on the surfaces of the electrode materials 8 (Cu members), and thereafter the Au plating layers were formed on the Ni plating layers. At this time, the thickness of each Ni plating layer was several µm, and the thickness of each Au plating layer was several hundred nm.

### 2. Evaluation of Thermoelectric Conversion Module

### (1) Thermal Durability Test

Total resistance values of the thermoelectric conversion modules of Examples 1 to 6 and Comparative Examples 1 and 2 were measured by using a resistance measuring device in an environment of 25°C. These values are defined as initial values.

The aforementioned each total resistance value refers to as an electric resistance value obtained by adding an "electrical resistance value of a thermoelectric conversion part" and an "interface electric resistance value between a thermoelectric conversion part and an electrode material". Herein, in a case where the bonding material (non-flowable bonding material, or the non-flowable bonding material + flowable bonding material) is used between the thermoelectric conversion part and the electrode material, the "electric resistance value of the bonding material itself", the "interface electric resistance value between the thermoelectric conversion part and the bonding material", and the "interface electric resistance value between the bonding material and the electrode material" are included in the aforementioned "interface electric resistance value between the thermoelectric conversion part and the electrode material".

Then, the thermoelectric conversion modules of Examples 1 to 6 and Comparative Examples 1 and 2, for which the initial value measurement was completed, were housed in a vacuum furnace. Thereafter, the inside of the vacuum furnace was depressurized to 5 × 10⁻³ Pa or less, and heated to 450°C. Then, the inside of the vacuum furnace was held in this state for 100 hours.

After elapse of 100 hours, each thermoelectric conversion module was cooled to 25°C, and taken out of the vacuum furnace. Then, the total resistance value of each thermoelectric conversion module was measured. The value at this time was defined as the total resistance value after the elapse of 100 hours.

Then, each thermoelectric conversion module, for which the total resistance value measurement after elapse of 100 hours was completed, was housed in the vacuum furnace again. Thereafter, the inside of the vacuum furnace was depressurized to 5 × 10⁻³ Pa or less, and heated to 450°C. Then, the inside of the vacuum furnace was further held in this state for 100 hours.

After the elapse of a total of 200 hours, each thermoelectric conversion module was cooled to 25°C, and taken out of the vacuum furnace. Then, the total resistance value of each thermoelectric conversion module was measured. The value at this time was defined as the total resistance value after the elapse of 200 hours.

For the total resistance values after the elapse of 100 hours and the total resistance values after the elapse of 200 hours obtained as described above, relative values in a case where the initial values were 100% were obtained, and the obtained results were taken as the values after the elapse of 100 hours and the values after the elapse of 200 hours to be illustrated in Table 1.

[Table 1]

**[Table 1]**

| | Surface Roughness (Rz) of Surface of Thermoelectric Conversion Part **[*µ*m]** | Method for Bonding Thermoelectric Conversion Element and Cu Member | Total Resistance Value | | |
|---|---|---|---|---|---|
| | | | Initial Value **[%]** | 100 Hour Elapse Value **[%]** | 200 Hour Elapse Value **[%]** |
| Example 1 | 1. 5±0. 1 | Direct Bonding | 100 | 99 | 99 |
| Example 2 | 4. 0±0. 2 | Direct Bonding | 100 | 104 | 108 |
| Example 3 | 1. 5 ± 0. 1 | Non-Flowable Bonding Material (Ni/Au Layer) | 100 | 96 | 96 |
| Example 4 | 4. 0±0. 2 | Non-Flowable Bonding Material (Ni/Au Layer) | 100 | 87 | 94 |
| Comparative Example 1 | 4. 7±0. 1 | Non-Flowable Bonding Material (Ni/Au Layer) | 100 | 198 | 218 |
| Example 5 | 1. 5±0. 1 | Non-Flowable Bonding Material (Ni/Au Layer) + Flowable Bonding Material (Ag Paste) | 100 | 95 | 102 |
| Example 6 | 4. 0±0. 2 | Non-Flowable Bonding Material (Ni/Au Layer) + Flowable Bonding Material (Ag Paste) | 100 | 134 | 220 |
| Comparative Example 2 | 4. 7±0. 1 | Non-Flowable Bonding Material (Ni/Au Layer) + Flowable Bonding Material (Ag Paste) | 100 | 407 | 506 |

### (2) Consideration

(i) In Examples 1 to 4 in which the Mo layer is included in the diffusion prevention layer, no significant increase in the total resistance value was found. It is conceivable that this is because when the Mo layer is included in the diffusion prevention layer, Sn in the stannide compound does not react with Mo in the diffusion prevention layer, and the function of the diffusion prevention layer is not impaired even when heating is performed for a long time.

It is conceivable that the reason why the total resistance value after the elapse of 100 hours is lower than the initial value is that the "interface electric resistance value between the thermoelectric conversion part and the electrode material" is reduced.

On the other hand, in Comparative Example 1 in which the Ni layer included in the diffusion prevention layer, the total resistance value increased significantly. It is conceivable that this is because the Ni layer included in the diffusion prevention layer reacts with Sn in the stannide compound, and the function as the diffusion prevention layer is impaired.

From the above, it can be said that when the Mo layer is included in the diffusion prevention layer, increase in the total resistance value of the thermoelectric conversion module can be suppressed, and a thermoelectric conversion module having excellent durability can be obtained.

(ii) From the results of Examples 5 and 6 and Comparative Example 2 using Ni and Au plating layers (non-flowable bonding materials) and Ag pastes (flowable bonding materials) as the bonding materials, the following can be found. First, from the results of Example 6, when the Ag paste is used, an Ag component in the Ag paste and an Mg component in the stannide compound react with each other, and the total resistance value increases. However, it can be found that when the surface roughness of the surface of the thermoelectric conversion part is made smaller than that of Example 6 as in Example 5, the increase in the total resistance value can be suppressed even when the Ag paste is used. Further, as in Comparative Example 2, when the Ag paste is used, the Ni layer is included in the diffusion prevention layer, and the surface roughness of the surface of the thermoelectric conversion part is made relatively large, namely, 4.7 ± 0.1 µm, it is found that the Ag component in the Ag paste reacts with the Mg component in the stannide compound, and the Ni layer and the Sn component in the stannide compound further react with each other, the total resistance value of the thermoelectric conversion module significantly increases, and durability is reduced.

Accordingly, it can be said that in a case where the Ag paste is used, it is effective in suppression of increase of the total resistance value of the thermoelectric conversion module that the Mo layer is included as the diffusion prevention layer, and the surface roughness of the surface of the thermoelectric conversion part is reduced as much as possible.

Herein, in the drawings referred in the description of the present invention, the thicknesses of the electrode material, each layer, and the thermoelectric conversion part and the ratios between the respective parts are exaggerated such that the configuration of each part can be easily understood, and are differ from the actual thicknesses and ratios.

The present invention is not limited to the aforementioned embodiments and examples, and various modifications can be made. In the aforementioned embodiments and examples, the diffusion prevention layers and the antioxidant layers are provided on the one end side and the other end side of the thermoelectric conversion part. However, the present invention is not limited to this embodiment, and these diffusion prevention layers and antioxidant layers only needs to be provided at least on the side exposed to a high temperature.

### <Aspect of Present Invention>

A first aspect of the present invention is a stannide thermoelectric conversion element including: a thermoelectric conversion part containing a stannide compound having composition represented by a general expression: Mg₂Si₁₋ₓSnₓ (where x satisfies relation of 0.5 < x < 1 in the expression); and a diffusion prevention layer located on a surface of the thermoelectric conversion part, wherein the diffusion prevention layer includes an Mo layer.

A second aspect of the present invention is the stannide thermoelectric conversion element in the aforementioned first aspect of the present invention, wherein the diffusion prevention layer further includes: a first adhesion layer disposed between the Mo layer and the thermoelectric conversion part; and a second adhesion layer disposed on a side opposite to the first adhesion layer so as to interpose the Mo layer.

A third aspect of the present invention is the stannide thermoelectric conversion element in the aforementioned second aspect of the present invention, wherein the first adhesion layer and the second adhesion layer each include a Ti layer.

A fourth aspect of the present invention is the stannide thermoelectric conversion element in any of the aforementioned first to third aspects of the present invention, wherein surface roughness Rz of the surface of the thermoelectric conversion part is 0.1 µm or more and 3 µm or less.

A fifth aspect of the present invention is the stannide thermoelectric conversion element in any of the aforementioned first to fourth aspects of the present invention, further including an antioxidant layer disposed on a side opposite to the thermoelectric conversion part so as to interpose the diffusion prevention layer.

A sixth aspect of the present invention is the stannide thermoelectric conversion element in the aforementioned fifth aspect of the present invention, wherein the antioxidant layer includes at least one metal layer of an Au layer, an Ag layer and a Cu layer.

A seventh aspect of the present invention is a stannide thermoelectric conversion module including: a thermoelectric conversion element; and an electrode material bonded to the thermoelectric conversion element with a bonding material therebetween, wherein the thermoelectric conversion element is the stannide thermoelectric conversion element of any of the first to sixth aspects of the present invention, and the bonding material includes a non-flowable bonding material having no fluidity.

An eighth aspect of the present invention is the stannide thermoelectric conversion module in the aforementioned seventh aspect of the present invention, wherein the non-flowable bonding material includes at least one of an Ni plating layer and an Au plating layer.

A ninth aspect of the present invention is the stannide thermoelectric conversion module in the aforementioned seventh aspect of the present invention, wherein the non-flowable bonding material includes foil made of Ag.

A tenth aspect of the present invention is a stannide thermoelectric conversion module including: a thermoelectric conversion element; and an electrode material directly bonded to the thermoelectric conversion element with no bonding material therebetween, wherein the thermoelectric conversion element is the stannide thermoelectric conversion element of any of the first to sixth aspects.

### Explanation of Reference Signs

2 stannide thermoelectric conversion element (thermoelectric conversion element)
4 stannide thermoelectric conversion module (thermoelectric conversion module)
6 bonding material
8 electrode material
16 thermoelectric conversion part
18 first diffusion prevention layer
20 first antioxidant layer
22 second diffusion prevention layer
24 second antioxidant layer
26, 27 Mo layer
28, 29 first adhesion layer
30, 31 second adhesion layer

## Claims

1. A stannide thermoelectric conversion element comprising:
a thermoelectric conversion part containing a stannide compound having composition represented by a general expression: Mg₂Si₁₋ₓSnₓ (where x satisfies relation of 0.5 < x < 1 in the expression); and
a diffusion prevention layer located on a surface of the thermoelectric conversion part, wherein
the diffusion prevention layer includes an Mo layer.

2. The stannide thermoelectric conversion element according to claim 1, wherein
the diffusion prevention layer further includes:
a first adhesion layer disposed between the Mo layer and the thermoelectric conversion part; and
a second adhesion layer disposed on a side opposite to the first adhesion layer so as to interpose the Mo layer.

3. The stannide thermoelectric conversion element according to claim 2, wherein
the first adhesion layer and the second adhesion layer each include a Ti layer.

4. The stannide thermoelectric conversion element according to any of claims 1 to 3, wherein
surface roughness Rz of the surface of the thermoelectric conversion part is 0.1 µm or more and 3 µm or less.

5. The stannide thermoelectric conversion element according to any of claims 1 to 4, further comprising an antioxidant layer disposed on a side opposite to the thermoelectric conversion part so as to interpose the diffusion prevention layer.

6. The stannide thermoelectric conversion element according to claim 5, wherein
the antioxidant layer includes at least one metal layer of an Au layer, an Ag layer and a Cu layer.

7. A stannide thermoelectric conversion module comprising:
a thermoelectric conversion element; and
an electrode material bonded to the thermoelectric conversion element with a bonding material therebetween, wherein
the thermoelectric conversion element is the stannide thermoelectric conversion element according to any of claims 1 to 6, and
the bonding material includes a non-flowable bonding material having no fluidity.

8. The stannide thermoelectric conversion module according to claim 7, wherein
the non-flowable bonding material includes at least one of an Ni plating layer and an Au plating layer.

9. The stannide thermoelectric conversion module according to claim 7, wherein
the non-flowable bonding material includes foil made of Ag.

10. A stannide thermoelectric conversion module comprising:
a thermoelectric conversion element; and
an electrode material directly bonded to the thermoelectric conversion element with no bonding material therebetween, wherein
the thermoelectric conversion element is the stannide thermoelectric conversion element according to any of claims 1 to 6.
